# EUROPEAN PATENT APPLICATION

(11) **EP 1 471 559 A1**
(43) Date of publication of application: **27.10.2004**
(21) Application number: 04251192.3
(22) Date of filing: 02.03.2004
(51) Int. Cl.: H01J 17/16, H01J 29/86, H05K 9/00

(54) **Electromagnetic wave shielding filter and method of manufacturing the same**

(30) Priority: 25.04.2003 KR 2003026391
(71) Applicant: Samsung SDI Co., Ltd., Suwon-si, Gyeonggi-do (KR)
(72) Inventor: Park, Hyun-Ki, Seoul (KR); Choi, Kwi-Seok, Yeongtong-gu, Suwon-si Gyeonggi-do (KR); Zang, Dong-Sik, Yeongtong-gu, Suwon-si, Gyeonggi-do (KR); Joo, Kyu-Nam, Mapo-gu Seoul (KR)
(74) Representative: Greene, Simon Kenneth

(57) **Abstract**

An electromagnetic wave shielding filter for a plasma display panel, for example, and a method of manufacturing such a filter includes preparing a substrate such as a metal plate that can act as a seed layer for electrolytic plating; forming a meshed plating layer on an upper surface of the metal plate; adhering an adhesive film to an upper surface of the plating layer; and separating the adhesive film from the metal plate so that the plating layer is adhered to a lower surface of the adhesive film. An electromagnetic wave shielding layer, which is installed to shield electromagnetic waves generated during the driving of a plasma display panel, for example, is formed in a mesh pattern, and the mesh pattern is created on a metal plate by electrolytic plating.

## Description

The present invention relates to an electromagnetic wave shielding filter, and more particularly, to an electromagnetic wave shielding filter for a plasma display panel, for example, the filter having an improved structure of a mesh layer formed on a substrate to effectively shield electromagnetic waves radiating from the plasma display panel. The present invention also relates to a method of manufacturing the electromagnetic wave shielding filter.

Generally, a plasma display panel (PDP) is a flat panel display device which produces desired figures, characters, or graphics by pixel addressing. Spaces defined between two substrates, in which a plurality of electrodes is installed, are filled with a discharge gas, and then the two substrates are sealed. When a discharge voltage is applied to the electrodes, light is generated by the discharge gas between opposite electrodes. When an appropriate pulse voltage is applied to the electrodes, pixels at the intersections of the opposite electrodes are addressed.

PDPs are classified into a direct current (DC) type and an alternating current (AC) type according to the driving voltages applied to discharge cells, for example, and are classified into discharge types, for example, an opposite discharge type and a surface discharge type according to electrode structures.

Japanese Laid-Open Patent Application Publication Nos. 99-167350 and 2002-62814, and U.S. Patent Nos. 6,229,085, 6,090,473, and 6,262,364 relate to examples of PDPs with an electromagnetic wave shielding layer.

Japanese Laid-Open Patent Application Publication Nos. 99-167350 and 2002-62814 relate to a transparent priming of filling voids of a mesh with an UV curing agent. In U.S. Patent No. 6,229,085, a mesh is formed to a thickness of about 0.1 micrometers using electroless plating and is then coated with an adhesive to fill voids in the mesh. In U.S. Patent Nos. 6,090,473 and 6,262,364, a mesh is sandwiched between two adhesive films made of ethylene-vinyl acetate copolymer.

However, PDPs with the above-described electromagnetic wave shielding layer have the following problems.

First, in the case of an electromagnetic wave shielding layer formed using an etching process, upon etching, a part of an adhesive may be peeled off from the surface of a transparent substrate or scorched. For these reasons, a process yield decreases, and thus, a production unit cost increases.

Second, in the case of adhering a meshed metal foil to a substrate using an adhesive, a nonuniform coating of the adhesive may lower transparency of the metal foil. Furthermore, if a solvent is insufficiently removed from the adhesive, it is difficult to ensure uniformity of coating. Still furthermore, the metal foil must have good wettability for the adhesive to prevent formation of air bubbles or gas bubbles derived from generated gases.

Third, due to voids in a mesh, an electromagnetic wave shielding layer exhibits haziness under visible light at all viewing angles, thereby not ensuring transparency. For this reason, transparent priming for filling voids in a mesh is required. As an example of such transparent priming, coating with a UV curing agent and then curing can be used. However, such series processes are somewhat complicated.

According to an aspect of the present invention, there is provided a method of manufacturing an electromagnetic wave shielding filter, the method comprising: preparing a metal plate for plating; forming an insulating layer on an upper surface of the metal plate, the insulating layer having a mesh pattern; forming a plating layer on a remaining upper surface of the metal plate on which the insulating layer is not formed; arranging an adhesive film on the metal plate having the insulating layer and the plating layer; adhering the adhesive film to upper surfaces of the insulating layer and the plating layer; and separating the adhesive film from the metal plate so that the plating layer is adhered to a lower surface of the adhesive film, the plating layer being in the form of a mesh. The adhesive film may be a polymer film.

According to another aspect of the present invention, there is provided a method of manufacturing an electromagnetic wave shielding filter, the method comprising: preparing a metal plate for plating; forming a photoresist layer on an upper surface of the metal plate, the photoresist layer having a mesh pattern; forming a plating layer on a remaining upper surface of the metal plate on which the photoresist layer is not formed; removing the photoresist layer from the metal plate; arranging an adhesive film on the metal plate having the plating layer; adhering the adhesive film to an upper surface of the plating layer; and separating the adhesive film from the metal plate so that the plating layer is adhered to a lower surface of the adhesive film, the plating layer being in the form of a mesh. The adhesive film may be a polymer film.

According to still another aspect of the present invention, there is provided a method of manufacturing an electromagnetic wave shielding filter, the method comprising: preparing a substrate; adhering a metal foil to an upper surface of the substrate; forming a photoresist layer on an upper surface of the metal foil, the photoresist layer having a mesh pattern; forming a plating layer on a remaining upper surface of the metal foil on which the photoresist layer is not formed; removing the photoresist layer from the metal foil; arranging an adhesive film on the metal foil having the plating layer; adhering the adhesive film to an upper surface of the plating layer; and separating the adhesive film from the metal foil so that the plating layer is adhered to a lower surface of the adhesive film, the plating layer being in the form of a mesh. The adhesive film may be a polymer film.

According to yet another aspect of the present invention, there is provided an electromagnetic wave shielding filter, manufactured by preparing a substrate, forming a meshed plating layer on an upper surface of the substrate, adhering an adhesive film to an upper surface of the plating layer, and separating the adhesive film from the substrate so that the plating layer is adhered to a lower surface of the adhesive film. The adhesive film may be a polymer film.

The present invention thus provides an electromagnetic wave shielding filter for a plasma display panel, for example, the filter having an improved structure of an electromagnetic wave shielding layer formed on a substrate to shield electromagnetic waves radiating from a panel assembly. The present invention also provides a method of manufacturing an electromagnetic wave shielding filter, the electromagnetic wave shielding filter having an improved structure of an electromagnetic wave shielding layer formed on a substrate.

The present invention also provides an electromagnetic wave shielding filter for a plasma display panel, for example, the filter having an improved structure of a meshed electromagnetic wave shielding layer for enhanced transparency and a method for manufacturing the same.

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:
FIG. 1 is a schematic view of an example of a conventional plasma display panel;
FIG. 2 is a sectional view of a conventional electromagnetic wave shielding layer;
FIG. 3 is an exploded perspective view of a plasma display panel according to an embodiment of the present invention;
FIG. 4 is an enlarged view of part "A" of FIG. 3;
FIGS. 5A through 5F are sectional views showing sequential processes of manufacturing an electromagnetic wave shielding layer according to a first embodiment of the present invention;
FIGS. 6A through 6G are sectional views showing sequential processes of manufacturing an electromagnetic wave shielding layer according to a second embodiment of the present invention;
FIGS. 7A through 7H are sectional views showing sequential processes of manufacturing an electromagnetic wave shielding layer according to a third embodiment of the present invention;
FIG. 8 is a sectional view of an electromagnetic wave shielding layer according to a fourth embodiment of the present invention;
FIG. 9 is a sectional view of an electromagnetic wave shielding layer according to a fifth embodiment of the present invention; and
FIG. 10 is a sectional view of an electromagnetic wave shielding layer according to a sixth embodiment of the present invention.

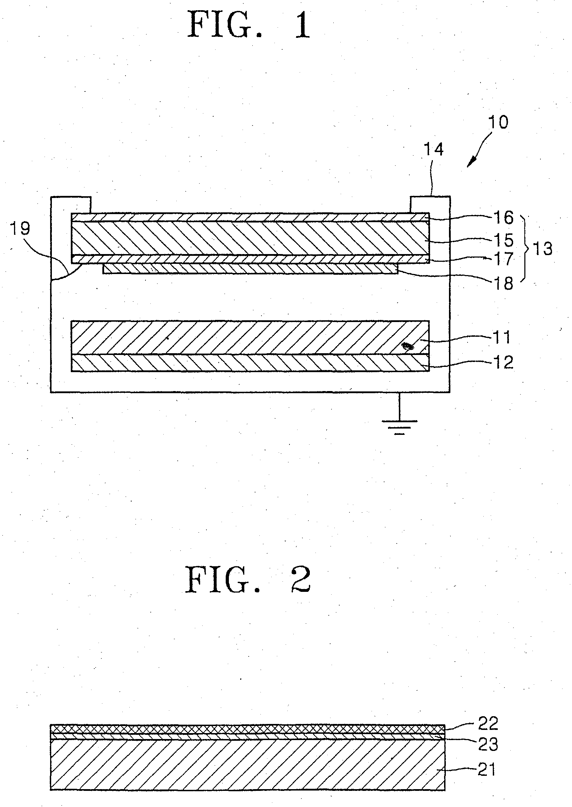

FIG. 1 is a schematic view of an example of a conventional PDP 10. Referring to FIG. 1, the PDP 10 comprises a panel assembly 11, a substrate 12 installed at a rear surface of the panel assembly 11, a filter assembly 13 installed at a front part of the panel assembly 11, and a case 14 for receiving the panel assembly 11, the substrate 12, and the filter assembly 13.

When the PDP 10 is driven, electromagnetic waves, infrared light, and neon light with a wavelength of about 590 nm, or the like are radiated. Since electromagnetic waves adversely affects the human body and the infrared light causes a portable electronic machine such as a remote controller to malfunction, it is necessary to shield the electromagnetic waves and infrared light. Neon light with a wavelength of 590 nm must be shielded to provide better image quality. In addition, an anti-reflective treatment is required to prevent reduction of visibility caused by reflection of external light.

The filter assembly 13 is installed to solve the above-described phenomena, and comprises a glass or plastic substrate 15, an anti-reflective film 16 formed on a front surface of the substrate 15, an electromagnetic wave shielding layer 17 formed on a rear surface of the substrate 15, and a wavelength selective absorption film 18 formed on a rear surface of the electromagnetic wave shielding layer 17.

The filter assembly 13 is manufactured by preparing the transparent substrate 15, forming the electromagnetic wave shielding layer 17 with a conductive film or metal mesh pattern on a surface of the substrate 15, and adhering the anti-reflective film 16 and the wavelength selective adsorption film 18 to the other surface of the substrate 15 and a surface of the electromagnetic wave shielding layer 17, respectively. When the electromagnetic wave shielding layer 17 is charged with an electric charge, it is connected and grounded to a chassis portion inside the case 14 via a conductive line 19.

Among the constitutional elements for the filter assembly 13, the electromagnetic wave shielding layer 17 has been formed by metal foil etching so as to shield electromagnetic waves generated by plasma radiation and PDP circuit itself during the driving of the PDP 10.

Referring to FIG. 2, a metal foil 22 is disposed on an upper surface of a transparent substrate 21. The metal foil 22 is adhered to the substrate 21 using an adhesive 23, and is blackened to create a black effect. The metal foil 22 is formed in a predetermined mesh pattern using a mesh-patterned mask. Such a mesh pattern is accomplished using an etching process. Voids in a mesh may be subjected to transparent priming using an UV curing agent. Alternatively, a meshed, metal film coated textile can be disposed on the upper surface of the substrate 21.

Hereinafter, electromagnetic wave filters for plasma display panels and their fabrication methods according to exemplary embodiments of the present invention will be described in detail with reference to the accompanying drawings.

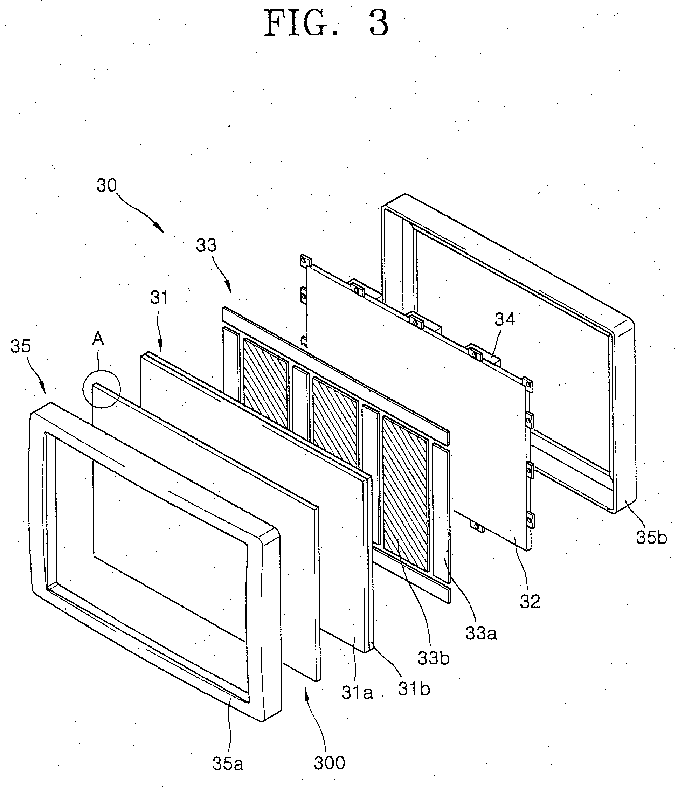

FIG. 3 shows a plasma display panel (PDP) 30 according to an embodiment of the present invention.

Referring to FIG. 3, the PDP 30 comprises a panel assembly 31; a chassis base 32 for supporting the panel assembly 31; an adhesive member 33 for combining the panel assembly 31 with the chassis base 32; a substrate 34 installed at a rear surface of the chassis base 32, and a case 35 for receiving the panel assembly 31, the chassis base 32, and the substrate 34.

The panel assembly 31 comprises a front panel 31a and a rear panel 31b. The front panel 31a comprises a plurality of sustaining electrodes; a plurality of bus electrodes electrically connected to the sustaining electrodes; a front dielectric layer for covering the sustaining and bus electrodes; and a protective layer coated on a surface of the front dielectric layer. The rear panel 31b is installed opposite to the front panel 31a, and comprises a plurality of address electrodes, a rear dielectric layer for covering the address electrodes, a plurality of barrier ribs for defining discharge spaces and preventing cross-talk, and a fluorescent layer coated on inner surfaces of the barrier ribs and comprised of red, green, and blue color components.

The chassis base 32 is installed at the rear surface of the panel assembly 31 to support the panel assembly 31.

The adhesive member 33 is disposed between the panel assembly 31 and the chassis base 32 to attach them together. The adhesive member 33 has a double-sided adhesive tape 33a and a radiating sheet 33b that allows heat generated from the panel assembly 31 to be released via the chassis base 32.

The substrate 34 is installed at the rear surface of the chassis base 32 and is provided with a plurality of electronic parts to transmit an electric signal to each of the electrodes of the panel assembly 31.

The case 35 comprises a front cabinet 35a installed at the front part of the panel assembly 31 and a cover 35b installed at the rear part of the chassis base 32 provided with the substrate 34. The case 35 receives the panel assembly 31 and the chassis base 32 that are attached together by the adhesive member 33 to protect them from external circumstances.

A filter assembly 300 is installed at the front part of the panel assembly 31 to shield electromagnetic waves, infrared light, and neon light, which are generated by the PDP 30, and to prevent reflection of external light.

The filter assembly 300 has a transparent substrate 310 made of transparent glass or plastic material.

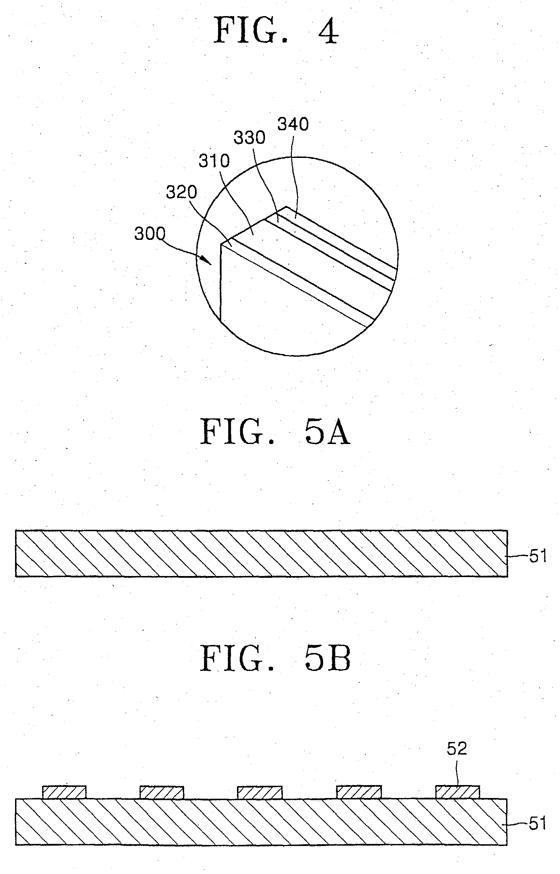

An anti-reflective film 320 is adhered to a front surface of the transparent substrate 310 to prevent reduction of visibility caused by reflection of external light, as shown in FIG. 4. The anti-reflective film 320 is subjected to an anti-reflective (AR) treatment.

An electromagnetic wave shielding layer 330 is formed at a rear surface of the transparent substrate 310 to efficiently shield electromagnetic waves generated during driving of the PDP 30.

A wavelength selective absorption film 340 is formed on the surface of the electromagnetic wave shielding layer 330 to shield neon light with a wavelength region of 590 nm and near-infrared rays radiated by an inert plasma gas used during screen radiation.

According to an embodiment of the present invention, a mesh pattern is formed on an upper surface of a metal plate for plating, a plating layer is formed on an exposed surface of the metal plate, and then the plating layer is separated from the metal plate using a film. The separated plating layer is used as the electromagnetic wave shielding layer 330 for shielding electromagnetic waves.

FIGS. 5A through 5F are sectional views showing sequential processes of manufacturing an electromagnetic wave shielding layer according to a first embodiment of the present invention.

First, a metal plate 51 for electrolytic plating is prepared, as shown in FIG. 5A. The metal plate 51 may be made of a metal material that can allow the metal plate 51 to act as a seed layer, for example, an alloy selected from SUS, a titanium alloy, a nickel alloy, a copper alloy, and an iron alloy.

An insulating layer 52 is formed on an upper surface of the metal plate 51, as shown in FIG. 5B. The insulating layer 52 has a shape corresponding to a mesh pattern to be formed later and corresponds to a non-plated region. The insulating layer 52 is formed by coating the metal plate 52 with oxide such as SiO₂, followed by sintering.

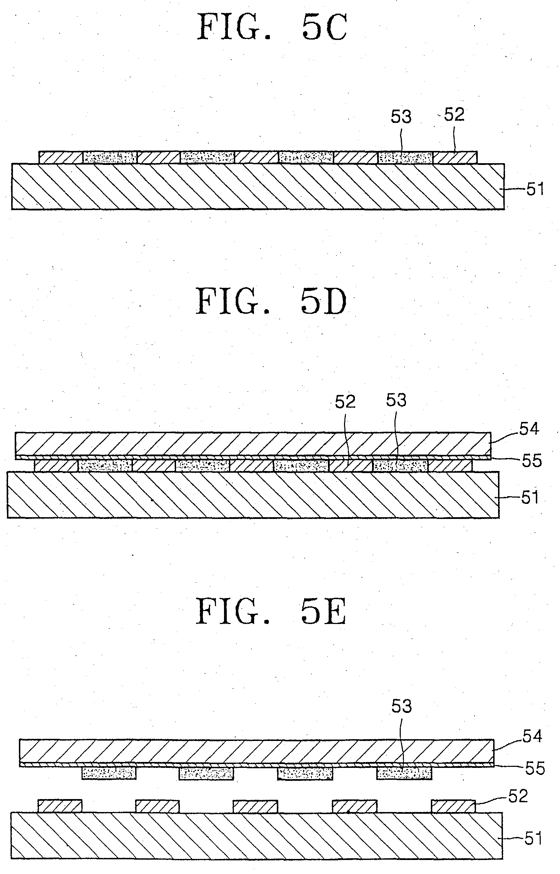

A plating layer 53 is formed on the remaining upper surface of the metal plate 51 on which the insulating layer 52 is not formed, as shown in FIG. 5C. The plating layer 53 is selectively formed on upper surface portions of the metal plate 51 corresponding to voids in the insulating layer 52. The plating layer 53 has a mesh pattern. The plating layer 53 is made of a conductive metal material such as copper or silver. The surface of the plating layer 53 may be blackened to increase contrast.

A film, for example polymer film 54, is arranged on the metal plate 51 having the insulating layer 52 and the plating layer 53 that are in the form of a mesh, as shown in FIG. 5D. The polymer film 54 is made of an insulating material, preferably, polyethylene terephthalate (PET). A lower surface of the polymer film 54 is coated with an adhesive 55. The lower surface of the polymer film 54, on which the adhesive is coated, is adhered to the upper surfaces of the insulating layer 52 and the plating layer 53. As an alternative to the polymer film 54, one of an anti-reflective film and a wavelength selective absorption film, which are respectively adhered to the front and rear surfaces of a substrate, may be used so as to reduce the total thickness of a filter assembly.

After the polymer film 54 is adhered to the upper surfaces of the insulating layer 52 and the plating layer 53, the polymer film 54 is separated from the metal plate 51. The plating layer 53 is adhered in the form of a mesh to the lower surface of the polymer film 54.

The insulating layer 52 has a strong binding force to the metal plate 51 because it is subjected to a sintering process after being coated on the metal plate 51. On the other hand, since the plating layer 53 is formed by electrolytic plating on the metal plate 51 made of a heterogeneous metal, i.e., a metal different from that for the plating layer 53, an interfacial binding force between the metal plate 51 and the plating layer 53 is much weaker than that between the metal plate 51 and the insulating layer 52. Therefore, upon separation of the polymer film 54 from the metal plate 51, the plating layer 53 is only adhered to the lower surface of the polymer film 54, as shown in FIG. 5E.

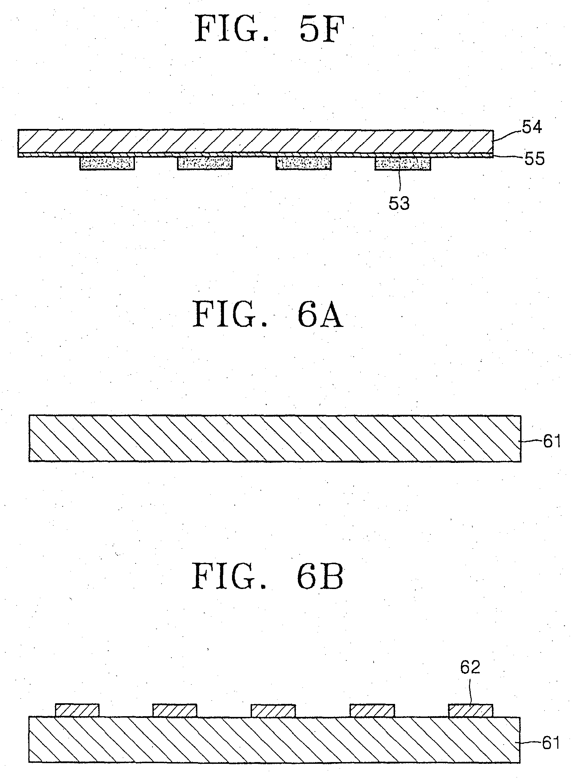

In this way, the plating layer 53 with the mesh pattern is formed on a surface of the polymer film 54 by using the metal plate 51 acting as a seed layer for electrolytic plating, as shown in FIG. 5F.

After the polymer film 54 is separated from the metal plate 51 such that the plating layer 53 is adhered to the lower surface of the polymer film 54, as shown in FIG. 5E, formation of the plating layer 53 as shown in FIG. 5C and sequential processes of the formation of the plating layer 53 can be repeatedly carried out on the metal plate 51.

FIGS. 6A through 6G are sectional views showing sequential processes of manufacturing an electromagnetic wave shielding layer according to a second embodiment of the present invention.

First, a conductive metal plate 61 that can act as a seed layer for electrolytic plating is prepared, as shown in FIG. 6A. The metal plate 61 may be made of an alloy selected from SUS, a titanium alloy, a nickel alloy, a copper alloy, and an iron alloy.

A photoresist layer 62 is formed on an upper surface of the metal plate 61, as shown in FIG. 6B. The photoresist layer 62 is formed by coating photoresist on the upper surface of the metal plate 61 using a photo mask with mesh pattern, followed by exposure, development, and curing. The photoresist layer 62 corresponds to a non-plated region.

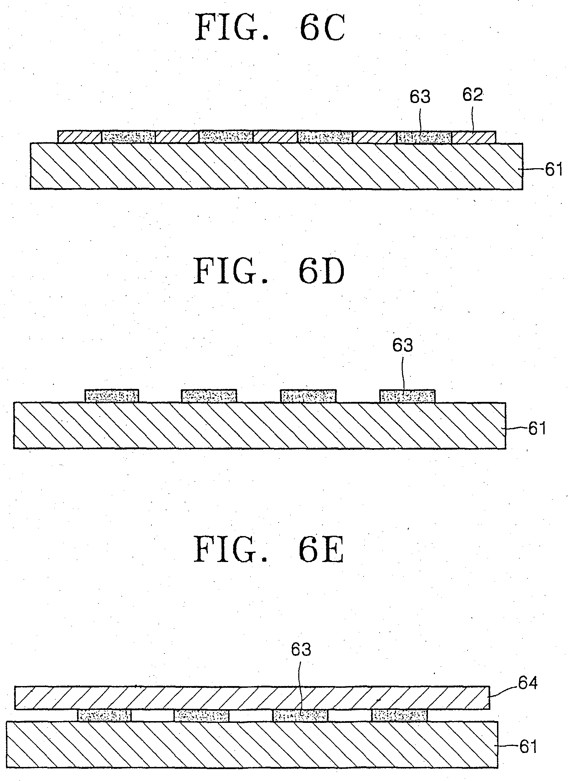

A plating layer 63 is formed on the metal plate 61 having the photoresist layer 62, as shown in FIG. 6C. The plating layer 63 is selectively formed on the remaining upper surface of the metal plate 61 on which the photoresist layer 62 is not formed. As a result, the plating layer 63 has a mesh pattern. The plating layer 63 may be made of a metal material such as copper or silver.

After the plating layer 63 is formed on the metal plate 61, the photoresist layer 62 is removed, as shown in FIG. 6D. As a result, the meshed plating layer 63 only is left on the upper surface of the metal plate 61.

A polymer film 64 made of PET is arranged on the metal plate 61 having only the plating layer 63, as shown in FIG. 6E. The polymer film 64 has an adhesive material on the lower surface thereof. Therefore, the polymer film 64 can be adhered to the upper surface of the plating layer 63.

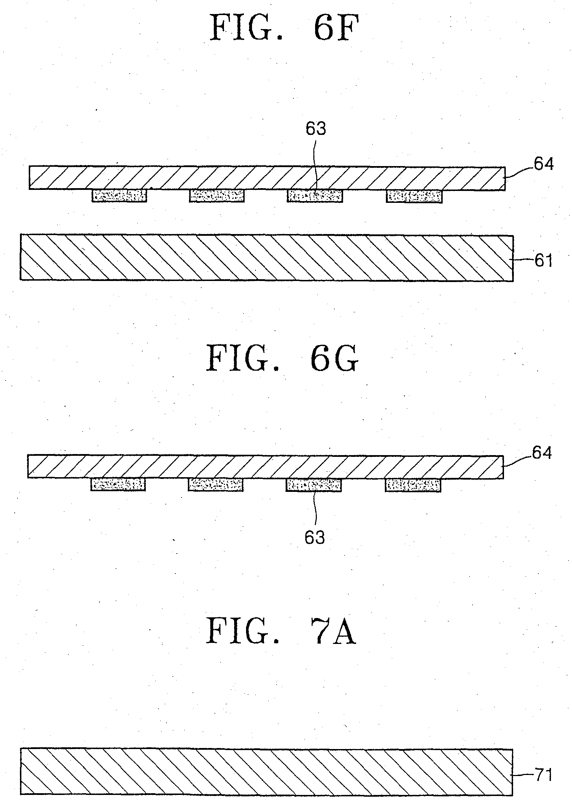

After the polymer film 64 is adhered to the upper surface of the plating layer 63, the polymer film 64 is separated from the metal plate 61, as shown in FIG. 6F. When the polymer film 64 is separated from the metal plate 61, the plating layer 63 is transferred to the lower surface of the polymer film 64 from the upper surface of the metal plate 61. A binding force of the plating layer 63 to the metal plate 61 is weaker than a binding force of the plating layer 63 to polymer film 64. Therefore, the plating layer 63 can be easily separated from the metal plate 61.

In this way, the plating layer 63 with the mesh pattern can be formed on the lower surface of the polymer film 64, as shown in FIG. 6G.

FIGS. 7A through 7H are sectional views showing sequential processes of manufacturing an electromagnetic wave shielding layer according to a third embodiment of the present invention.

First, a substrate 71 is prepared, as shown in FIG. 7A. The substrate 71 is a glass substrate with excellent evenness. Alternatively, the same metal plates for electrolytic plating as used in the first and second embodiments can be used.

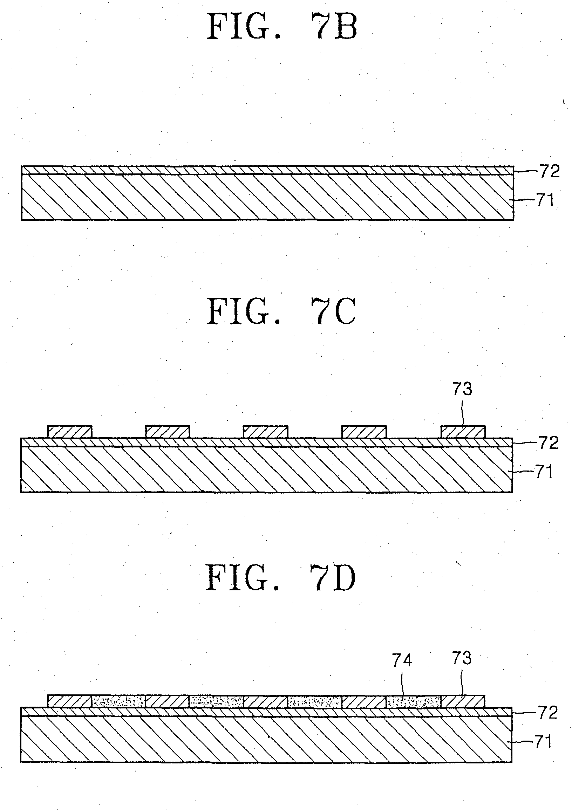

A metal foil 72 is adhered to an upper surface of the substrate 71 using an adhesive, as shown in FIG. 7B. The metal foil 72 is made of a conductive metal material, for example, an alloy selected from SUS, a titanium alloy, a nickel alloy, a copper alloy, and an iron alloy. The metal foil 72 has a thickness of 0.03 to 0.5 mm.

A photoresist layer 73 is formed on the metal foil 72 using photolithography, as shown in FIG. 7C. The photoresist layer 73 has a shape corresponding to a mesh pattern and corresponds to a non-plated region. The photoresist layer 73 must have the substantially same thickness as a plating layer 74 to be formed later. This is because if the thickness of the plating layer 74 exceeds the thickness of the photoresist layer 73, the metal material for the plating layer 74 spreads in all directions, and thus, a plating pattern error can be caused.

After the photoresist layer 73 is formed on the metal foil 72, the plating layer 74 is formed on the metal foil 72, as shown in FIG. 7D. The plating layer 74 is selectively formed on the remaining upper surface of the metal foil 72 that are exposed through voids in the photoresist layer 73. The plating layer 74 is made of a conductive material such as copper or silver. The plating layer 74 has a thickness of 10 to 15 µm.

After the plating layer 74 is formed on the substrate 71, the plating layer 74 may be blackened to prevent surface oxidation of the plating layer 74 and to enhance a black effect. For example, the plating layer 74 may be dipped in a sodium hydroxide solution for surface oxidation and blackening.

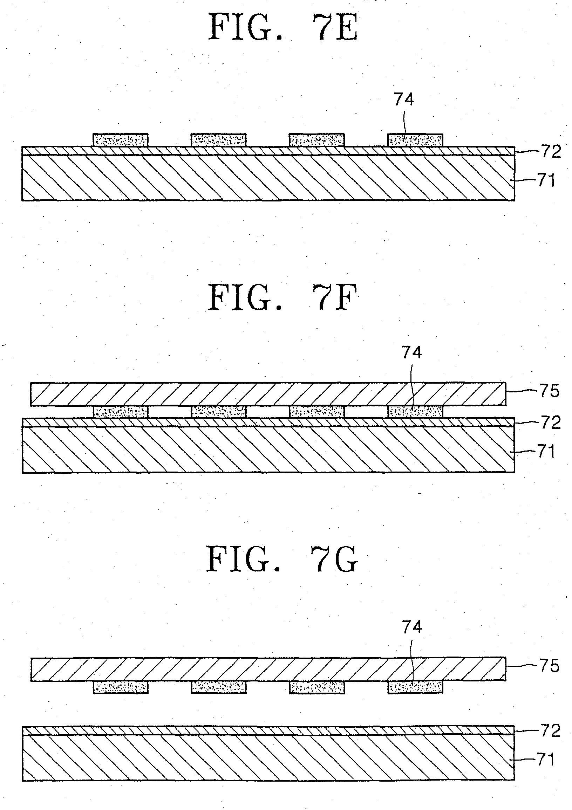

Next, the photoresist layer 73 is removed, as shown in FIG. 7E. As a result, the meshed plating layer 74 is only left on the metal foil 72. Since the plating layer 74 is made of a heterogeneous metal, i.e., a metal different from that for the metal foil 72, a binding force of the plating layer 74 to the metal foil 72 is very weak.

After drying, a polymer film 75 is arranged on the substrate 71 and then adhered to the surface of the plating layer 74, as shown in FIG. 7F. The polymer film 75 has an adhesive material on the lower surface thereof. Therefore, adhesion of the polymer film 75 to the upper surface of the plating layer 74 is accomplished. In view of reduction of the total thickness of a filter assembly, one of an anti-reflective film and a wavelength selective absorption film, which are respectively adhered to the front and rear surfaces of a substrate, may be used as the polymer film 75.

After the polymer film 75 is adhered to the upper surface of the plating layer 74 on the substrate 71, the polymer film 75 is separated from the substrate 71, as shown in FIG. 7G. The plating layer 74 is then peeled off from the metal foil 72 while being adhered in the form of a mesh to the lower surface of the polymer film 75.

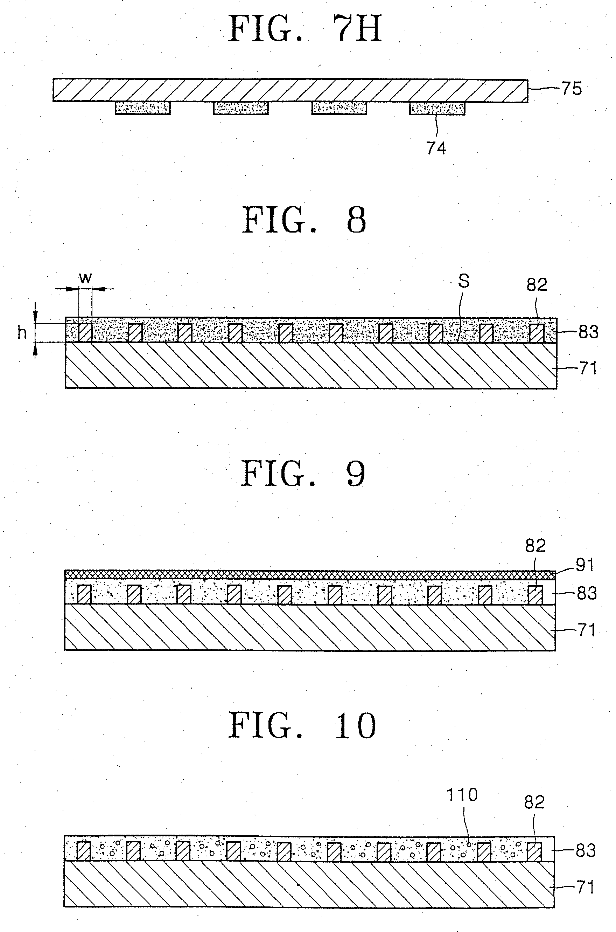

In this way, the plating layer 74 with the mesh pattern is formed on a surface of the polymer film 75, as shown in FIG. 7H.

The substrate 71 having the metal foil 72, which acts as a seed layer for electrolytic plating, can be repeatedly used after separation of the polymer film 75 with the plating layer 74 from the substrate 71.

Voids are present in a film with a mesh pattern. Due to such voids in the meshed film, upon PDP driving, the meshed film exhibits haziness, by which visible light is observed in an opaque form. In order to prevent such haziness, the meshed film may be subjected to transparent priming.

For example, with reference to FIG. 8, a plating layer 82 is patterned on a substrate 71. The plating layer 82 is adhered to the substrate 71 by an adhesive layer. The substrate 71 is one of a transparent glass substrate and a polymer film.

The plating layer 82 has a mesh pattern, and thus, voids S are present in the meshed plating layer 82. In order to efficiently shield electromagnetic waves, it is preferable that the plating layer 82 has a linewidth (w) of 5 to 20 µm and a height (h) of 20 µm or less.

A transparent layer 83 is formed on the plating layer 82 to cover the plating layer 82. The transparent layer 83 is made of a transparent resin material to fill the voids S and thus eliminate the haze phenomenon. Preferably, the resin material is an acrylic resin containing an acrylic solid such as an acrylate or butyl carbitol. The resin material contains about 5% of the acrylic solid. The transparent layer 83 coated on the plating layer 82 is cured with a predetermined heat. The transparent layer 83 is formed to a height of about 10 to 100 µm.

FIG. 9 shows the structure of a separate adhesive layer 91 coated on the transparent layer 83.

The plating layer 82 formed to the mesh pattern on the substrate 71 is covered with the transparent layer 83 made of a material with excellent transparency such as an acrylic resin. As a result, the voids formed in the meshed plating layer 82 are filled with the transparent layer 83. The adhesive layer 91 is formed on the upper surface of the transparent layer 83 covering the plating layer 82. The adhesive layer 91 serves to adhere the transparent layer 83 to other substrate or film. The transparent layer 83 is coated to a height of about 10 to 100 µm and the adhesive layer 91 is coated to a height of about 5 µm or less.

As shown in FIG. 10, the transparent layer 83 may also contain an adhesive 110. In detail, the plating layer 82 formed to the mesh pattern on the substrate 71 is covered with the transparent layer 83 made of a material with excellent transparency such as an acrylic resin. The transparent layer 83 can contain a small amount of the adhesive 110, for example, about 10% or less, so as to be sticky. The transparent layer 83 containing the adhesive 110 is coated to a height of 10 to 100 µm and then dried at a temperature range of 70 to 150 C.

In addition, the transparent layer 83 may further contain an absorbent of light with a wavelength region of about 590 nm. Also, the meshed plating layer 82 covered with the transparent layer 83 may be adhered to a glass or plastic substrate after formed on a polymer film, or it may also be directly adhered to a substrate, on which an adhesive is coated, but various other changes thereof may be made.

As apparent from the above descriptions, an electromagnetic wave shielding filter for a PDP of the present invention and a fabrication method therefor can provide the following advantages.

First, an electromagnetic wave shielding layer installed for shielding electromagnetic waves generated during PDP driving has a mesh pattern, which is formed on a metal plate by electrolytic plating. Therefore, a manufacturing process is simplified and a production cost is reduced.

Second, the metal plate for electrolytic plating can be repeatedly used in the formation of a plating layer with a mesh pattern. Therefore, a production cost can be reduced.

Third, an electromagnetic wave shielding layer can have a uniform mesh pattern because the mesh pattern is formed by electrolytic plating. Therefore, product yield is increased.

Fourth, since voids in the meshed plating layer are filled with acrylic polymer resin, a haze phenomenon is prevented. Therefore, transparency of the electromagnetic wave shielding layer can be remarkably enhanced.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A method of manufacturing an electromagnetic wave shielding filter, the method comprising:
preparing a substrate;
forming a material layer on an upper surface of the metal plate, the material layer having an inverse mesh pattern;
forming a plating layer on a remaining upper surface of the metal plate on which the material layer is not formed;
arranging an adhesive film on the metal plate having the plating layer;
adhering the adhesive film to upper surfaces of the plating layer; and
separating the adhesive film from the metal plate so that the plating layer is adhered to a lower surface of the adhesive film, the plating layer being in the form of a mesh.

2. The method according to claim 1, wherein:
preparing a substrate comprises preparing a metal plate for plating; and
the material layer is an insulating layer.

3. The method according to claim 1, wherein:
preparing a substrate comprises preparing a metal plate for plating;
the material layer is a photoresist layer; and
the method further comprises, after forming a plating layer and before arranging an adhesive film, removing the photoresist layer from the metal plate.

4. The method of claim 1, wherein:
the method further comprises, after preparing a substrate and before forming a material layer, adhering a metal foil to an upper surface of the substrate;
the material layer is a photoresist layer; and
the method further comprises, after forming a plating layer and before arranging an adhesive film, removing the photoresist layer from the metal plate.

5. The method according to claim 2, wherein the insulating layer is formed by oxide coating.

6. The method according to any one of claims 2 to 5, wherein the metal plate or metal foil comprises an alloy selected from at least one of SUS, a titanium alloy, a nickel alloy, a copper alloy, and an iron alloy, the metal plate or metal foil acting as a seed layer for electrolytic plating.

7. The method according to any one of claims 2 to 6, wherein the plating layer comprises at least one of copper or silver.

8. The method according to any one of claims 2 to 7, wherein the adhesive film comprises polyethylene terephthalate.

9. The method according to any one of claims 2 to 8, wherein the adhesive film comprises a polymer film.

10. The method according to any one of claims 2 to 9, wherein a binding force of the plating layer to the adhesive film is stronger than a binding force of the plating layer to the metal plate or metal foil.

11. The method according to any one of the preceding claims, further comprising blackening the surface of the plating layer to increase contrast, after forming the plating layer.

12. An electromagnetic wave shielding filter, manufactured by the method according to any one of the preceding claims.

13. An electromagnetic wave shielding filter, manufactured by preparing a substrate, forming a meshed plating layer on an upper surface of the substrate, adhering an adhesive film to an upper surface of the plating layer, and separating the adhesive film from the substrate so that the plating layer is adhered to a lower surface of the adhesive film.

14. The electromagnetic wave shielding filter according to claim 13, wherein the substrate is a metal plate arranged to act as a seed layer for electrolytic plating.

15. The electromagnetic wave shielding filter according to claim 14, wherein the metal plate comprises an alloy selected from at least one of SUS, a titanium alloy, a nickel alloy, a copper alloy, or an iron alloy.

16. The electromagnetic wave shielding filter according to any one of claims 13 to 15, wherein the plating layer comprises at least one of copper or silver.

17. The electromagnetic wave shielding filter according to any one of claims 13 to 16, wherein the surface of the plating layer is blackened.

18. The electromagnetic wave shielding filter according to any one of claims 13 to 17, wherein the adhesive film comprises polyethylene terephthalate.

19. The electromagnetic wave shielding filter according to any one of claims 13 to 18, wherein the adhesive film comprises a polymer film.

20. The electromagnetic wave shielding filter according to any one of claims 13 to 19, wherein a transparent layer containing an acrylic solid is further arranged on the upper surface of the meshed plating layer to cover voids in the meshed plating layer.

21. The electromagnetic wave shielding filter according to claim 20, wherein the transparent layer comprises at least one of an acrylate or a butyl carbitol.

22. The electromagnetic wave shielding filter according to claim 21, wherein the transparent layer comprises 10% or less of an adhesive.

23. A plasma display panel comprising the electromagnetic wave shielding filter according to any one of claims 13 to 22.
